# EUROPÄISCHE PATENTSCHRIFT

(11) **EP 4 139 642 B1**
(45) Veröffentlichungstag und Bekanntmachung des Hinweises auf die Patenterteilung: **08.05.2024**
(21) Anmeldenummer: 21722385.8
(22) Anmeldetag: 21.04.2021
(51) Int. Cl.: G01J 3/10, H01L 33/50, G01J 3/02

(54) **VERFAHREN ZUR DETEKTION EINES SPEKTRUMS UND SPEKTROSKOPIEANORDNUNG**
METHOD FOR DETECTING A SPECTRUM, AND SPECTROSCOPY ASSEMBLY
PROCÉDÉ DE DÉTECTION D'UN SPECTRE ET ENSEMBLE DE SPECTROSCOPIE

(30) Priorität: 22.04.2020 DE 102020205119
(43) Veröffentlichungstag der Anmeldung: 01.03.2023
(73) Patentinhaber: ams-OSRAM International GmbH, 93055 Regensberg (DE)
(72) Erfinder: PLECHINGER, Gerd, 93051 Regensburg (DE)
(74) Vertreter: Engelhardt, Martin
(86) Internationale Anmeldenummer: PCT/EP2021/060445
(87) Internationale Veröffentlichungsnummer: WO 2021/214178

(56) Entgegenhaltungen:
- EP-A1- 3 370 309
- DE-A1-102018 118 079
- DE-A1-102018 213 377
- DE-A5-112016 001 966
- US-A1- 2006 164 004
- US-A1- 2020 309 348

## Beschreibung

Die vorliegende Anmeldung nimmt die Priorität der deutschen Patentanmeldung DE102020205119.4 vom 22. April 2020 in Anspruch.

Die vorliegende Erfindung betrifft ein Verfahren zur zeitlich differenzierten Detektion eines Spektrums eines Objektes sowie ein Spektroskopieanordnung.

Eine typische Anwendung optoelektronische Bauelemente und Sensoren besteht in einer spektroskopischen Untersuchung von Testobjekten. Hierbei wird vereinfacht gesagt, ein Testobjekt mit einem Licht einer ersten Wellenlänge bestrahlt und das von dem Testobjekt reflektierte oder transmittierte Licht detektiert. Aus der Menge des detektierten Lichts bzw. auch dessen spektrale Verteilung kann auf das Objekt bzw. Parameter davon zurückgeschlossen werden.

Derzeitig auf dem Markt befindliche mobile Spektroskopie Anwendungen umfassen oftmals eine Leuchtdiode deren Infrarotspektrum relativ breitbandig ist. Diese Leuchtdiode wird durch ein optoelektronisches Bauelement mit einem dazugehörigen Konversions-farbstoff gebildet, der das von dem optoelektronischen Bauelement sichtbare Licht beispielsweise blaues Licht in den infraroten Spektralbereich konvertiert. Das so konvertierte Licht wird auf die zu untersuchende Probe gesandt, und von dieser reflektiert bzw. transportiert. Es fällt dann auf eine Detektorzelle und kann so detektiert werden.

Bei den gängigen Anwendungen umfasst die Detektorzelle einen Fotodetektor mit einem spektralen schmalbandigen Filter, sodass lediglich ein eng umgrenzter Wellenlängenbereich durch den Detektor erfasst wird. Über das Verhältnis der Signalintensität der einzelnen Detektoren kann dadurch ein Reflexions- bzw. Transmissionsspektrum generiert und ausgewertet werden.

Jedoch gibt es gegenwärtig nur wenig Leuchtstoffmischungen, die das benötigte und infrage kommende Infrarotspektrum im Bereich von 700-1050 NM abdecken können. Hinzu kommt, dass der Leuchtstoff nicht das vollständige vom elektronischen Bauelementen abgestrahlte Licht konvertiert, sodass auch noch unkonvertiertes Licht von dem Testobjekt reflektiert bzw. transmittiert wird. Dabei kann die Intensität des nicht konvertierten Lichts im Spektrum um einen mehrfachen Faktor höher sein als die mittlere Intensität im infraroten Spektralbereich. Entsprechend benötigt man für die Anwendung einen geeigneten Abschwächfilter mit hohen Betriebsströmen. Der über dem Detektor angebrachte Filter reduziert somit die optische Leistung auch in dem benötigten Spektralbereich, sodass das Signal zu Rausch Verhältnis verschlechtert wird.

Eine alternative Lösung für die genannten Probleme besteht darin, mehrere verschiedene optoelektronische Bauelemente mit unterschiedlichem Spektralbereich zu verwenden und damit das Spektrum eines Breitbandermittlers nachzubilden. Jedoch werden hierzu eine Vielzahl optoelektronischer Bauelemente benötigt, sodass der Platzbedarf entsprechend ansteigt. Hinzu kommt das bei einer Messung im sichtbaren und Infrarotbereich zusätzliche Bauelemente zur Erzeugung von Licht im sichtbaren Spektralbereich benötigt werden. Der große Platzbedarf erschwert somit Spektroskopieanwendungen für mobile Endgeräte.

Aus der DE 10 2018 213377 A1 ist ein Spektrometer mit einem lumineszierenden Element zur Wandlung eines ersten Anteils der ersten elektromagnetischen Strahlung mit dem ersten Spektrum in eine zweite elektromagnetische Strahlung mit einem zweiten Spektrum.

Es besteht damit das Bedürfnis, ein Verfahren sowie ein Modul bereitzustellen, welches auch für mobile Endgeräte geeignet ist und insbesondere mit einem geringeren Platzbedarf auskommt.

Diesem Bedürfnis wird mit einem Verfahren gemäß Anspruch 1 zur zeitlich differenzierten Detektion eines Spektrums sowie einer entsprechenden Spektroskopieanordnung gemäß Anspruch 15 Rechnung getragen. Hierbei wurde erkannt, dass Konversionsfarbstoffe bei einem einstrahlenden Lichtimpuls nicht unmittelbar, sondern zeitlich versetzt das einfallende Licht konvertieren. Dies ergibt sich aus der Tatsache, dass die eine Lichtkonversion erzeugenden angeregten Zustände des Konversionsfarbstoffs eine gewisse Lebensdauer haben. Durch diese Lebensdauer verbleiben die Ladungsträger im angeregten Zustand und fallen somit erst nach einiger Zeit in den Grundzustand unter Aussendung von Licht im Infrarot bzw. im konvertierten Spektralbereich zurück. Die Erfindung macht sich diesen Umstand in dem Verfahren sowie in dem Spektroskopie Modul zu Nutze.

Es wird somit ein Verfahren zur zeitlich differenzierten Detektion eines Spektrums eines Testobjekts vorgeschlagen, bei dem in einem ersten Schritt ein erster Konversionsfarbstoff bereitgestellt wird. Der Konversionsfarbstoff ist ausgestaltet, Licht mit einer ersten spektralen Verteilung im sichtbaren Bereich in Licht mit einer zweiten spektralen Verteilung im Infrarotbereich zu konvertieren. Diese Konversion kann über mindestens und im Besonderen über Fluoreszenz oder Phosphoreszenz höchstens erfolgen. Dabei bezeichnet Fluoreszenz einen Prozess, bei dem in einem physikalischen System eine von außen zugeführte Energie absorbiert wird und zu einem angeregten Zustand des physikalischen Systems führt. Dieser angeregte Zustand fällt zurück in den Grundzustand unter Aussendung von Licht im sichtbaren oder unsichtbaren Bereich. Für den Fall, dass zwischen der Absorption der Energie und der darauffolgenden Emission kein zusätzlicher Aktivierungsprozess notwendig ist, wird von Fluoreszenz gesprochen. Hingegen bezeichnet der Begriff Phosphoreszenz einen Prozess, bei dem ein zusätzlicher Aktivierungsprozess meistens in Form eines photonischen Stoßes oder ähnlichem notwendig ist. Mit anderen Worten erfolgt bei einer Fluoreszenz ein Übergang vom angeregten in den Grundzustand über einen sogenannten erlaubten Übergang. Dieser zeichnete sich durch eine besonders geringe Lebensdauer aus. Hingegen erfolgt bei der Phosphorresistenz eine Abstrahlung von Licht durch einen nicht erlaubten Übergang, der einen Aktivierungs-prozess benötigt und somit eine deutlich längere Lebensdauer aufweist.

Diese Lebensdauer macht man sich bei der Wahl des Konversionsfarb-stoffes dem vorgeschlagenen Verfahren zu Nutze. In einem zweiten Schritt des Verfahrens wird der erste Konversionsfarbstoff mit einem Lichtimpuls im Bereich der ersten spektralen Verteilung während einer ersten Zeitdauer angeregt. Dieser Lichtpuls der ersten spektralen Verteilung kann beispielsweise im sichtbaren Bereich liegen. Innerhalb dieser ersten Zeitdauer wird nun während eines ersten Zeitraums eines von dem Testobjekt reflektierten oder transmittierten Lichtanteils im Bereich der ersten spektralen Verteilung erfasst. Der erste Zeitraum liegt dabei im Wesentlichen innerhalb mindestens einer Lebensdauer für den ersten Konversionsfarbstoff.

Während einer zweiten Zeitdauer nach der ersten Zeitdauer wird zudem der von dem Testobjekt reflektierte oder transmittierte Anteil des konvertierten Lichts gemessen.

Mit dem vorgeschlagenen Verfahren wird somit der reflektierte oder transmittierte Anteil eines Lichts im Bereich der ersten spektralen Verteilung zum Beispiel im sichtbaren Bereich und anschließend eines Anteils von Licht im zweiten Spektralbereich, d. h. des konvertierten Lichts beispielsweise im zweiten Bereich gemessen. Die Erfassung des Anteils des Lichts im Bereich der ersten spektralen Verteilung erfolgt während des ersten Zeitraums, da innerhalb dieses Zeitraums noch keine Konversion des Lichts durch den Konversionsfarbstoff stattgefunden hat. Dies ergibt sich aus der Mindestlebensdauer für den ersten Konversionsfarbstoff. Mit anderen Worten ist der erste Zeitraum so kurz gewählt, dass dieser geringer ist als die Lumineszenzlebensdauer für den ersten Konversionsfarbstoff.

Während der zweiten Zeitdauer, die sich in einem Aspekt an die erste Zeitdauer unmittelbar anschließt, wird nun lediglich der Lichtanteil des konvertierten Lichts erfasst, jedoch kein Anteil des Lichtpulses, d. h. des Lichts im Bereich der ersten spektralen Verteilung. Mit dem vorgeschlagenen Verfahren wird somit zeitlich differenziert ein unterschiedlicher spektraler Anteil von Licht durch eine Fotodiode erfasst und gemessen. Dadurch kann die Fotodiode besonders einfach, d. h. ohne aufwendigen Filter ausgebildet werden. Gleichzeitig wird auch der Platzverbrauch reduziert, da eine Leuchtdiode mit Konversionsfarbstoff sowohl Licht im Bereich der ersten spektralen Verteilung als auch Licht im Bereich der zweiten spektralen Verteilung emittiert und der Fotodetektor Licht in beiden spektrale Bereichen erfassen kann.

Wie erwähnt kann sich die zweite Zeitdauer an die erste Zeitdauer unmittelbar anschließen. Dies ist zweckmäßig, da nach abschalten des Lichtpulses lediglich konvertiertes Licht vorhanden ist und dieses mit einer hohen Intensität von Konversionsfarbstoff abgegeben wird. Durch den exponentiellen Abfall des konvertierten Lichtanteils bietet es sich an, die zweite Zeitdauer unmittelbar nach oder kurz nach abschalten des Lichtpulses zu setzen.

In einem weiteren Aspekt wird ein zweiter Konversionsfarbstoff bereitgestellt, der ausgestaltet ist, das Licht mit der ersten oder zweiten spektralen Verteilung in Licht mit einer dritten spektralen Verteilung im Infrarotbereich zu konvertieren. Der zweite Konversionsfarbstoff wird mit dem ersten Lichtpuls angeregt. Nach der Anregung wird das von dem Testobjekt reflektierte oder transmittierte Licht des konvertierten Lichts mit der dritten spektralen Verteilung während einer dritten Zeitdauer nach der zweiten Zeitdauer erfasst. Mit diesem Aspekt können somit durch den Lichtpuls verschiedene Konversionsfarbstoffe angeregt werden. Diese Konversionsfarbstoffe zeichnen sich durch unterschiedliche Mindestlebensdauern aus, sodass das von den Konversionsfarbstoffen konvertierte Licht zu unterschiedlichen Zeitpunkten emittiert wird. Hierbei ist es in einem Aspekt vorgesehen, dass die Lumineszenzlebensdauer des zweiten Konversionsfarbstoffs länger ist als eine Summe aus der ersten und der zweiten Zeitdauer. Dadurch erfolgt eine Emission von konvertierten Licht durch den zweiten Konversionsfarbstoff erst nach dem Lichtpuls sowie der Konversion des Lichtpulses durch den ersten Konversions-farbstoff. Mit anderen Worten ist in einem Aspekt ein Beginn der dritten Zeitdauer so gewählt, dass dieser nach einem Abklingen der Lumineszenz durch den ersten Konversionsfarbstoff liegt. Dadurch hängt der Beginn der dritten Zeitdauer von einer Relaxationsdauer des ersten Konversionsfarbstoffs stark ab und ist im Besonderen so gewählt, dass im Wesentlichen keine Lumineszenz durch den ersten Konversionsfarbstoff stattfindet.

In diesem Aspekt kann so mit einem einzelnen Lichtimpuls und einer geeigneten Wahl verschiedener Konversionsfarbstoffe und deren Lebens dauern ein unterschiedliches Spektrum konvertierten Lichts aufgenommen werden.

In einem anderen Aspekt wird ein zweiter Konversionsfarbstoff bereitgestellt, der Licht mit der ersten spektralen Verteilung oder einer vierten spektralen Verteilung in Licht mit einer dritten spektralen Verteilung im infraroten Bereich konvertiert. Der zweite Konversionsfarbstoff wird mit einem Lichtimpuls im Bereich der ersten oder der vierten spektralen Verteilung während einer fünften Zeitdauer angeregt. In einem Aspekt kann die fünfte Zeitdauer nach der dritten Zeitdauer liegen. Während eines zweiten Zeitraumes innerhalb der fünften Zeitdauer wird nun ein von dem Testobjekt reflektierter oder transmittierter Lichtanteil im Bereich der ersten bzw. der vierten spektralen Verteilung erfasst. Anschließend wird, während einer sechsten Zeitdauer nach der fünften Zeitdauer das von dem Testobjekt reflektierte oder transmittierte konvertierte Licht, detektiert und erfasst.

Durch diesen vorgeschlagenen Aspekt werden somit zu zeitlich unterschiedlichen Zeitpunkten Lichtpulse für jeweilige Konversionsfarb-stoffe erzeugt, die nach der jeweiligen Lumineszenzlebensdauer des Farbstoffes zu einer Emission von konvertierten Licht führen. Ein durch das Testobjekt reflektierter bzw. transmittierter Anteil des nicht konvertierten Lichts wird zu Beginn des jeweiligen Licht-pulses, d. h. noch vor dem Einsetzen einer Lumineszenz des jeweiligen Konversionsfarbstoffs erfasst. Nach Ende des jeweiligen Lichtpulses wird dann das von dem jeweiligen Konversionsfarbstoff emittierte konvertierte Licht von dem Testobjekt reflektiert bzw. transmittiert und anschließend gemessen.

Für das vorgeschlagene Verfahren sind der erste und der zweite Konversionsfarbstoff jeweils so ausgestaltet, dass lediglich ein Teil des Lichts mit der ersten bzw. der vierten spektralen Verteilung durch den Farbstoff nicht konvertiert wird. In einem Aspekt wird durch den ersten bzw. zweiten Lichtimpuls somit ein Licht vorzugsweise im sichtbaren Bereich auf den Konversionsfarbstoff gegeben. Ein Teil dieses Lichts tritt durch den Konversionsfarbstoff hindurch und kann so dem Testobjekt zugeführt werden. Dieser Lichtanteil wird nach einer Reflexion oder anteiligen Transmission von dem Detektor erfasst. In einem Aspekt wird Licht mit der ersten bzw. der dritten spektralen Verteilung im sichtbaren Bereich lediglich zu 30-70 % und im Besonderen zu 45-55 % konvertiert.

In einem weiteren Aspekt wird während einer vierten Zeitdauer ein Umgebungslichtanteil erfasst. Diese vierte Zeitdauer liegt nach der zweiten Zeitdauer, der dritten oder der sechsten Zeitdauer. Durch das Erfassen des Umgebungslichtanteils kann somit ein Restlicht detektiert und für die weitere Signalverarbeitung verwendet werden. In einem weiteren Aspekt ist der Beginn der vierten Zeitdauer von einer Relaxationsdauer des ersten und oder zweiten Konversionsfarbstoffs abhängig. Insbesondere ist dieser Beginn so gewählt, dass im Wesentlichen keine Lumineszenz im ersten und oder im zweiten Konversions-farbstoff stattfindet. Der Umgebungslichtanteil wird somit nach dem Abklingen der Lumineszenz durch den jeweiligen Konversionsfarbstoff bestimmt, sodass lediglich das Umgebungslicht jedoch keine übrige Lumineszenz erfasst wird.

Ein weiterer Aspekt betrifft eine Spektroskopieanordnung, bei der wenigstens ein erstes optoelektronisches Bauelement vorgesehen ist. Dieses ist ausgestaltet, in einem Betrieb Licht in einem Bereich einer ersten spektralen Verteilung, insbesondere im sichtbaren Bereich abzugeben. Im Strahlengang des optoelektronischen Bauelements ist ein erster Konversionsfarbstoff angeordnet. Dieser ist ausgestaltet, Licht in einer ersten spektralen Verteilung im sichtbaren Bereich, in Licht in einer zweiten spektralen Verteilung im Infrarotbereich zu konvertieren. Der Konversionsfarbstoff erzeugt somit aus Licht im sichtbaren Bereich ein Licht im infraroten Bereich. Des Weiteren umfasst die Spektroskopieanordnung einen optischen Sensor, der ausgestaltet ist, Licht in der ersten spektralen Verteilung und in der zweiten spektralen Verteilung zu erfassen.

Erfindungsgemäß ist eine Kontrollschaltung vorgesehen, die mit dem wenigstens einen optoelektronischen Bauelement und dem optischen Sensor gekoppelt ist. Des Weiteren steuert die Kontrollschaltung den Sensor derart an, dass ein von dem optischen Emitter erzeugtes Signal sowohl während eines Zeitraums innerhalb der ersten Zeitdauer als auch in einer der ersten Zeitdauer nachfolgenden zweiten Zeitdauer erfasst wird. Der erste Zeitraum ist dabei so gewählt, dass dieser im Wesentlichen innerhalb einer Lumineszenzlebensdauer des ersten Konversionsfarbstoffs in der ersten Zeitdauer liegt.

Damit steuert die Kontrollschaltung das optoelektronische Bauelement sowie den optischen Sensor in einem Zeitmultiplexverfahren an, sodass ein von einem Testobjekt reflektiertes bzw. transmittiertes Licht erfasst wird. Dieses Licht ist einerseits das von dem wenigstens einen optoelektronischen Bauelement abgestrahlte und nicht konvertierte Licht während des ersten Zeitraums sowie ein von dem Testobjekt reflektiertes bzw. transmittiertes konvertiertes Licht während einer darauffolgenden zweiten Zeitdauer.

Auf diese Weise kann der optische Sensor einfach ausgestaltet werden, da Lichtsignale mit unterschiedlichen spektrale Anteilen zu unterschiedlichen Zeiten erfasst werden. Die vorgeschlagene Spektroskopieanordnung ist damit in der Lage, ein Testobjekt breitbandig, d. h. in einem großen Frequenzbereich des sichtbaren und infraroten Spektrums zu untersuchen.

In einem weiteren Aspekt umfasst die Spektroskopieanordnung einen zweiten Konversionsfarbstoff, der im Strahlengang des optoelektronischen Bauelements angeordnet ist. Dieser ist ausgestaltet, Licht in der ersten spektralen Verteilung in Licht in einer dritten spektralen Verteilung im Infrarotbereich zu konvertieren. Die Kontrollschaltung ist zudem ausgebildet, ein von dem optischen Sensor erzeugtes Signal während einer dritten Zeitdauer zu erfassen. Die dritte Zeitdauer folgt der zweiten Zeitdauer nach. Des Weiteren zeigt der zweite Konversionsfarbstoff eine Lumineszenzlebensdauer, die länger ist als eine Summe aus der ersten und zweiten Zeitdauer.

Mit anderen Worten wird bei diesem Aspekt das von dem Sensor erfasste reflektierte bzw. transmittierte Signal während der dritten Zeitdauer lediglich durch eine Lumineszenz des zweiten Konversions-farbstoffs hervorgerufen. Dadurch ist gewährleistet, dass das von dem Sensor erfasste Signal während der dritten Zeitdauer lediglich von dem zweiten Konversionsfarbstoff verursacht wird und nicht von einer noch anhaltenden Lumineszenz des ersten Konversionsfarbstoffs.

Zu diesem Zweck ist in einem Aspekt vorgesehen, dass ein Beginn der dritten Zeitdauer von einer Relaxationsdauer des ersten Konversions-farbstoffs abhängt. Der Beginn der dritten Zeitdauer kann damit im Besonderen so gewählt werden, dass im Wesentlichen keine Lumineszenz durch den ersten Konversionsfarbstoff mehr stattfindet.

Ein weiterer Aspekt betrifft eine Ergänzung der vorgeschlagenen Spektroskopieanordnung. Bei dieser ist ein zweites optoelektronisches Bauelement vorgesehen, welches in einem Betrieb Licht in einem Bereich einer vierten spektralen Verteilung im sichtbaren Bereich abgibt. In dem Strahlengang des zweiten optoelektronischen Bauelements ist ein zweiter Konversionsfarbstoff angeordnet, der Licht aus dem Bereich der vierten spektralen Verteilung in Licht in einer dritten spektralen Verteilung im Infrarotbereich konvertiert. Nach diesem Prinzip ist die Kontrollschaltung zudem ausgeführt, während einer fünften Zeitdauer das zweite optoelektronische Bauelement zur Erzeugung eines zweiten Lichtpulses anzusteuern. Ein von dem optischen Sensor erzeugtes Signal während eines zweiten Zeitraums innerhalb der fünften Zeitdauer wird durch die Kontrollschaltung erfasst. Zudem erzeugt der Sensor ebenfalls während einer sechsten Zeitdauer ein Signal, welches einen Lumineszenzlichtanteil des zweiten Konversionsfarbstoffs enthält. Die sechste Zeitdauer liegt dabei nach der fünften Zeitdauer.

Der oben angesprochene zweite Zeitraum ist in diesem Aspekt so gewählt, dass er im Wesentlichen innerhalb einer Lumineszenzlebensdauer für den zweiten Konversionsfarbstoff in der fünften Zeitdauer liegt.

Mit diesem vorgeschlagenen Prinzip wird eine Spektroskopieanordnung realisiert, bei dem mehrere optoelektronischen Bauelemente mit einem jeweils darüber angeordneten Konversionsfarbstoff nacheinander angesteuert werden. Gleichzeitig wird das von einem optischen Sensor detektierte Licht von einer Kontrollschaltung erfasst. Das Erfassen erfolgt ebenfalls zeitlich abgestimmt, sodass zum einen jeweils nicht konvertierte Lichtanteile der jeweiligen optoelektronischen Bauelemente detektiert werden und zum anderen die von einem Testobjekt reflektierten bzw. transmittierten Anteile eines durch den jeweiligen Konversionsfarbstoff konvertierten Lichts. Dadurch wird die Spektroskopieanordnung besonders breitbandig, d. h., sie ist imstande ein Spektrum sowohl im sichtbaren als auch im Infrarotbereich zu erfassen.

In einem weiteren Aspekt ist die Kontrollschaltung ausgestaltet, ein von dem optischen Sensor erzeugtes Signal während einer vierten Zeitdauer zu erfassen. Hierbei liegt die vierte Zeitdauer nach der zweiten Zeitdauer, der dritten Zeitdauer oder sechsten Zeitdauer. Bei diesem Aspekt wird der optische Sensor von der Kontrollschaltung derart angesteuert, dass er ein Restlicht bzw. ein Umgebungslicht empfängt und dieses an die Kontrollschaltung zur weiteren Auswertung weiterleitet. Durch eine Auswertung des Rest- bzw. Umgebungslichts lässt sich das Signalzu-Rausch-Verhältnis der Spektroskopieanordnung verbessern.

Zweckmäßigerweise erfolgt in einem Aspekt eine Messung des Restlichts bzw. des Umgebungslichts zu einem Zeitpunkt, bei dem im Wesentlichen keine Lumineszenz mehr durch den ersten bzw. zweiten Konversionsfarbstoff stattfindet. Damit hängt ein Beginn einer Messung für das Rest- bzw. Umgebungslicht von einer Relaxationsdauer des ersten und zweiten Konversionsfarbstoffs ab. Im Folgenden wird die Erfindung unter Bezugnahme auf die Figuren im Detail erläutert. So zeigen nun:
Figur 1 ein Ausführungsbeispiel einer Spektroskopieanordnung nach dem vorgeschlagenen Prinzip;
Figur 2 ein Zeitdiagramm mit verschiedenen Zeitpunkten sowie Zeitdauern zur Erläuterung des vorgeschlagenen Prinzips;
Figur 3 eine weitere Darstellung verschiedener Zeitdauern mit korrespondierenden Lumineszenzverläufen;
Figur 4 erstes Ausführungsbeispiel eines Verfahrens zur zeitlich differenzierten Detektion eines Spektrums eines Testobjekts;
Figur 5 ein Zeitdiagramm mit Signalen zur Ansteuerung der optoelektronischen Bauelemente bzw. der Fotodiode sowie den dazu korrespondierenden zeitlichen Verläufen der Konversionsfarbstoffe.
Figur 6 ein weiteres Ausführungsbeispiel des vorgeschlagenen Verfahrens, welches zu der Ausführungsform der Figur 5 korrespondiert.

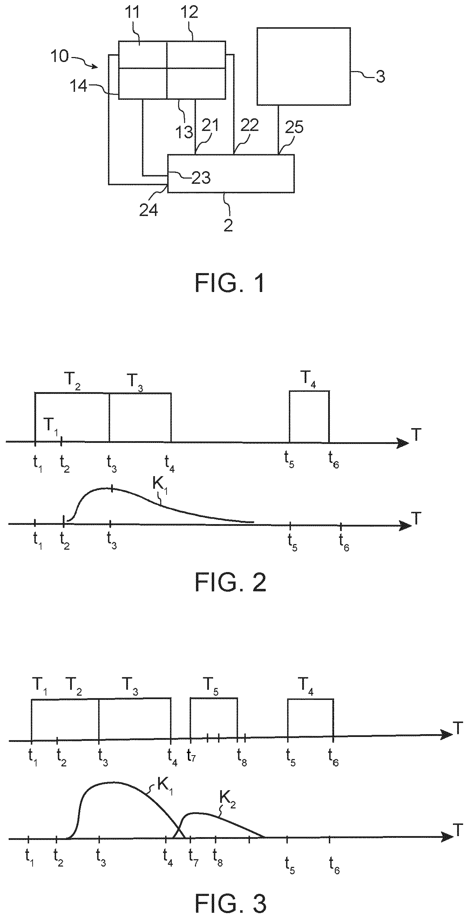

Figur 1 zeigt eine Ausführungsform einer Spektroskopieanordnung mit einigen Aspekten des vorgeschlagenen Prinzips. Die Spektroskopieanordnung 10 umfasst ein Array mit mehreren in einer Matrix angeordneten optoelektronischen Bauelementen 11, 12, 13 und 14. Hierbei sind beispielhaft 4 optoelektronische Bauelemente in einer 2x2 Matrix angeordnet, es können je nach Anwendung und Anforderung jedoch auch zusätzliche oder weniger Bauelemente sein. Jedes optoelektronische Bauelement ist ausgeführt, im Betrieb ein Licht in einem vordefinierten Spektralbereich des sichtbaren Lichts abzugeben. Beispielsweise erzeugt das optoelektronische Bauelement 11 blaues Licht, das optoelektronische Bauelement 12 grünes Licht, das Bauelement 13 die Farbe Orange sowie das Bauelement 14 rotes Licht. Durch eine geeignete gemeinsame Ansteuerung lassen sich neben den einzelnen unterschiedlichen Farben auch Mischfarben realisieren, sodass mit der hier dargestellten Anordnung das sichtbare Spektrum breitbandig überdeckt werden kann.

Jedes optoelektronische Bauelement umfasst darüber hinaus einen Konversionsfarbstoff, der auf das jeweilige optoelektronische Bauelement 11 bis 14 abgestimmt ist. Dieser ist im Strahlengang des jeweiligen optoelektronischen Bauelements angeordnet. Der jeweilige Konversionsfarbstoff ist ausgeführt, das von dem optoelektronischen Bauelemente abgegebene Licht zumindest teilweise in Licht im Infrarotspektrum zu konvertieren.

Ähnlich wie bei den elektronischen Bauelementen sind auch die Konversionsfarbstoffe so gewählt, dass sie ihr konvertiertes Licht in jeweilig unterschiedlichen Bereichen des infraroten Spektrums abgeben. Mit einer derartigen Anordnung kann somit ein breitbandiger Emitter geschaffen werden, dessen optoelektronischen Bauelemente gemeinsam mit den Konversionsfarbstoffen jeweils Leuchtdioden bilden, die sowohl im sichtbaren als auch im Infrarotbereich emittieren.

Die Spektroskopieanordnung umfasst weiterhin einen optischen Sensor in Form einer Fotodiode 3. Die Diode ist ausgeführt, das von den optoelektronischen Bauelementen 11 bis 14 abgegebene Licht zu empfangen und in ein entsprechendes Signal abhängig von der empfangenen Intensität zu wandeln. Die Fotodiode 3 ist dabei besonders einfach, d. h. ohne zusätzlichen Filter ausgeführt. Zur Korrektur eines Frequenzgangs, d. h. einer unterschiedlichen Sensitivität auf die jeweiligen spektralen Anteile kann die Diode 3 der Spektroskopieanordnung im Vorfeld geeicht werden. Ebenso ist es möglich, durch entsprechende Maßnahmen einen möglichst flachen und gleichförmigen Frequenzgang zu erhalten.

Zudem umfasst die Spektroskopieanordnung 10 eine Kontrollschaltung 2. Die Schaltung 2 ist ausgangsseitig zur Ansteuerung mit jedem der optoelektronischen Bauelemente 11 bis 14 gekoppelt. Zudem ist die Kontrollschaltung über den Eingang 25 mit der Fotodiode 3 verbunden.

Im Betrieb der vorgeschlagenen Spektroskopieanordnung steuert die Kontrollschaltung 2 durch jeweilig entsprechende Signale aus den Ausgängen 21 bis 24 die korrespondierenden optoelektronischen Bau-elemente einzeln an. Die Ansteuerung erfolgt dabei zeitlich versetzt, sodass in einem Ausführungsbeispiel lediglich eines der optoelektronischen Bauelemente aktiv ist. Während dieser Zeitdauer sendet das optoelektronische Bauelement somit Licht im sichtbaren Bereich aus. Das abgegebene Licht wird zum Teil von dem Konversions-farbstoff absorbiert, der damit in einen angeregten Zustand versetzt wird. Gleichzeitig wird ein weiterer Lichtanteil unkonvertiert abgestrahlt und trifft auf das zu untersuchende Objekt. Von diesem es in Richtung auf die Fotodiode 3 reflektiert. Entsprechend dem detektierten Licht erzeugt die Fotodiode 3 nun ein Signal und gibt dieses an die Kontrollschaltung zurück. Nach Einsetzen der Lumineszenz des Konversionsfarbstoffs wird auch dieser reflektierte Anteil erfasst und zurückgestrahlt. Durch eine geeignete zeitliche Auswahl der von der Fotodiode abgegebenen Signale und einer Ansteuerung der Fotodioden können die einzelnen von dem Testobjekt reflektierten bzw. transmittierten Anteile des unkonvertierten und konvertierten Lichts erfasst und gemessen werden.

Ein derartiges Ausführungsbeispiel hinsichtlich des zeitlichen Ablaufs für die Ansteuerung des optoelektronischen Bauelements und einer nachfolgenden Detektion in Figur 2 gezeigt.

Zum Zeitpunkt t1 bis zum Zeitpunkt t3 wird das optoelektronische Bauelement durch die Kontrollschaltung aktiviert. Dadurch wird ein Lichtimpuls abgegeben und auf den Konversionsfarbstoff K1 im Strahlengang des jeweiligen Bauelements geleitet. Die Zeitdauer zwischen den Zeitpunkten t1 bis t3 wird als Zeitdauer T2 bezeichnet. Wie im unteren Teil der Figur 2 zu erkennen, erfolgt eine Lumineszenz des Konversionsfarbstoffs K1 jedoch nicht gleichzeitig mit Beginn des vom optoelektronischen Bauelement abgegebenen Lichtpulses, sondern zeitlich versetzt. Dies liegt daran, dass der vom Bauelement abgegebene Lichtpuls zumindest teilweise vom Konversionsfarbstoff K1 absorbiert und dieser somit in einen höheren angeregten Zustand versetzt wird.

In diesem energetisch angeregten Zustand verbleibt der Konversions-farbstoff für eine Zeit, bis er durch Emission eines Photons wieder in den Grundzustand oder in einen niedrigeren Zustand zurückfällt. Der Zeitraum wird auch als Lebensdauer und im Besonderen als Lumineszenzlebensdauer bezeichnet. Hierbei betrifft der Begriff Lumineszenzlebensdauer den Zeitraum, in dem das angeregte System im angeregten zustand verbleibt, bevor es unter Aussendung eines Photons wieder in den Grundzustand oder einen niedrigeren Zustand übergeht. Je nach Übergang, d.h. ob dieser spontan oder nach einer Aktivierung, z.B. durch Stoß oder Impulsübertrag erfolgt, ist diese Lebensdauer länger oder kürzer. Als Fluoreszenz wird im allgemeinen eine Lumineszenz mit einem spontanen Übergang und kurzer Lebensdauer bezeichnet. Phosphoreszenz bezeichnet eine Lumineszenz mit einem Übergang nach einer Aktivierung, woraus generell eine Lebensdauer als bei der Fluoreszenz resultiert.

Im vorliegenden Beispiel beginnt somit eine Lumineszenz des Konversionsfarbstoffs K1 erst kurz nach dem Zeitpunkt t2. Während der Zeit zwischen t1 und t2 wird kein konvertiertes Licht abgegeben, da während dieses Zeitraums noch keine Konversion stattfindet. Man kann auch sagen, dass während dieses Zeitraums der Konversionsfarbstoff gepumpt wird, d. h. in einen angeregten Zustand versetzt wird. Nach dem Zeitpunkt t2 beginnt die Lumineszenz des Konversionsfarbstoffs K1 beispielsweise mit einem exponentiellen Anstieg bis zu einem bestimmten Maximum. Dieses Maximum ist noch während der Zeitdauer T2, d. h. vor dem Zeitpunkt t3 erreicht. Insofern stellt sich in diesem Ausführungsbeispiel somit ein Gleichgewichtszustand zwischen abgegebenen konvertierten Licht und absorbierten Licht ein.

Ab dem Zeitpunkt t3 wird nun der Lichtpuls ausgeschaltet. Dadurch erfolgt eine weitere Lichtabgabe lediglich durch den Farbstoff. Dadurch detektiert während der Zeitdauer T3 der optische Sensor lediglich einen konvertierten Lichtanteil. Aus dem Signalverlauf und einer bekannten Intensitätsabnahme kann somit die Lichtmenge während der Zeitdauer T3 durch die Kontrollschaltung erfasst werden. Nach einer gewissen Zeit ist die Lumineszenz des Konversionsfarbstoffs K1 soweit abgesunken, sodass die Intensität der Lumineszenz durch den Konversionsfarbstoff vernachlässigbar geworden ist. Ab dem Zeitpunkt t5 bis zum Zeitpunkt t6, d. h. während der Zeitdauer T4 wird somit von dem optischen Sensor lediglich ein Umgebungslichtanteil detektiert.

Somit erfolgt bei dem vorgeschlagenen Prinzip ein Erfassen der unterschiedlichen Lichtanteile zu jeweils unterschiedlichen Zeiten, ohne dass zusätzliche Maßnahmen wie Filter und Ähnliches für die Fotodiode oder den optischen Sensor vorgesehen werden müssen. Während der ersten Zeitdauer T1 somit lediglich das nicht konvertierte, sowie das Umgebungslicht durch die Fotodiode erfasst. Während der Zeitdauer T3, die sich an den Lichtpuls anschließt, detektiert die Fotodiode weiterhin das Umgebungslicht und einen von dem Konversionsfarbstoff konvertierten Lichtanteil. Während der Detektion zwischen den Zeitpunkten T5 und T6 wird lediglich das Umgebungslicht erfasst und kann somit von den vorangegangenen Messwerten abgezogen werden.

Figur 3 zeigt eine ergänzende Ausführungsform, bei dem vorliegend zwei Konversionsfarbstoffe K1 und K2 mit unterschiedlich langen Lumineszenzlebensdauern vorgesehen sind. Die beiden Konversionsfarb-stoffe K1 und K2 werden durch den gleichen Lichtpuls angeregt.

Während des Zeitraums T1 innerhalb der Zeitdauer T2 wird lediglich unkonvertiertes Licht sowie das Umgebungslicht von der Fotodiode erfasst. Zum Zeitpunkt t2 schaltet die Kontrollschaltung den optischen Sensor ab, während das optoelektronische Bauelemente weiterhin Licht emittiert. Kurz nach dem Zeitpunkt t2 erfolgt ein steiler Anstieg in der Lumineszenz des ersten Konversionsfarbstoffs K1. Zu dem Zeitpunkt t3 ist diese mindestens des ersten Konversionsfarbstoffs K1 im Gleichgewicht mit der Anregung durch das optische elektronische Bau-element. t3 ist auch der Zeitpunkt, bei dem das optische, elektronische Bauelemente durch die Kontrollschaltung abgeschaltet wird, dass nunmehr lediglich das durch den ersten Konversionsfarbstoff konvertierte Licht sowie das Umgebungslicht auf den Fotodetektor fällt.

Während der Zeitdauer T3 erfasst nun der optische Sensor eine Intensität des konvertierten Lichts des ersten Konversionsfarbstoffs K1. Die Lumineszenz nimmt bis zum Ende der Zeitdauer T3 hinweg leicht ab und verringert sich zunehmend bis zum Zeitpunkt t7. Gleichzeitig steigt jedoch die Lumineszenz des zweiten Konversionsfarbstoffs K2 an. Dies ergibt sich daraus, dass der zweite Konversionsfarbstoff K2 eine deutlich längere Lumineszenzlebensdauer als der erste Konversionsfarbstoffs K1 aufweist. D. h., während der Zeitdauer T2, in der das optoelektronische Bauelement aktiv geschaltet ist, wird auch der zweite Konversionsfarbstoff K2 in einen angeregten Zustand versetzt. Dieser angeregte Zustand hat eine längere Lebensdauer, sodass der Farbstoff erst ab dem Zeitpunkt T7 eine für die Messung ausreichend hohe Lumineszenz zeigt. Entsprechend wird, während der Zeitdauer T5 nun von dem optischen Sensor das von einem Testobjekt reflektierte Lumineszenzlicht des zweiten Konversionsfarbstoffs K2 erfasst. Auch die Intensität des zweiten Konversionsfarbstoffs K2 nimmt über die Zeit hinweg ab, sodass zum Zeitpunkt t5 die Lumineszenz der ersten und zweiten Konversionsfarbstoffe K1, K2 im Wesentlichen vernachlässigbar sind. Dadurch kann, während der Zeitdauer T4 zwischen den Zeitpunkten t5 und t6 wiederum nur das Umgebungslicht durch den optischen Sensor erfasst und von den vorangegangenen Signalen subtrahiert werden.

Durch die Ausnutzung von Konversionsfarbstoffen mit unterschiedlicher Lumineszenzlebensdauer lässt sich so ein Spektrum erfassen, welches aus dem Emissionsspektrum eines optoelektronischen Bauelements in Kombination mit den Spektren von verschiedenen Konversions-farbstoffen gebildet wird.

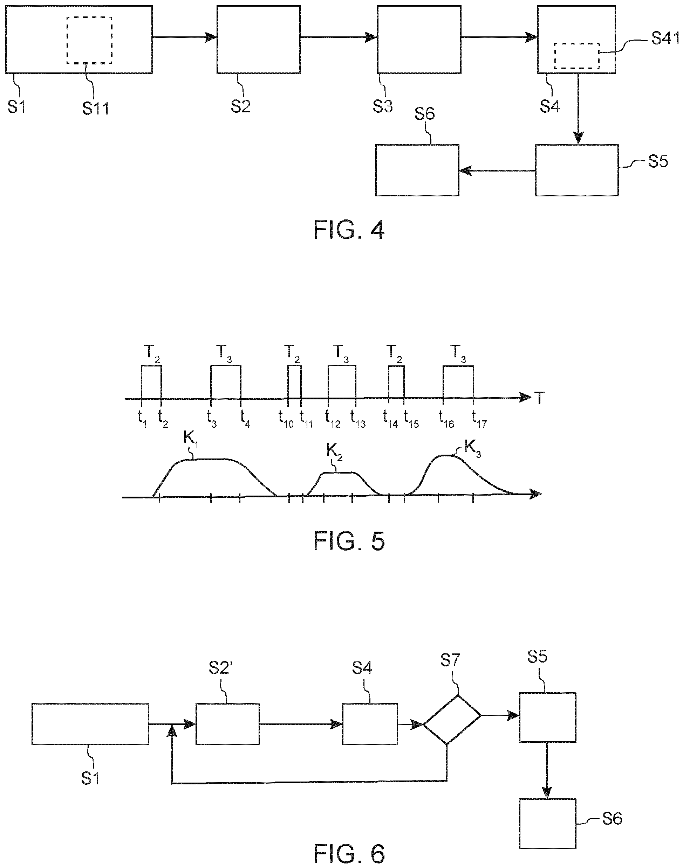

Figur 4 zeigt diesbezüglich ein Ausführungsbeispiel eines Verfahrens zur zeitlich differenzierten Detektion eines Spektrums eines Testobjektes nach dem vorgeschlagenen Prinzip. In Schritt S1 wird ein erster Konversionsfarbstoff bereitgestellt, der imstande ist, Licht mit oder in einer ersten spektralen Verteilung im sichtbaren Bereich, in Licht einer zweiten spektralen Verteilung im Infrarotbereich zu konvertieren. In einem darauffolgenden zweiten Schritt wird der erste Konversionsfarbstoff nun mit einem Lichtpuls im Bereich der ersten spektralen Verteilung angeregt. Dieser Lichtpuls erfolgt während einer ersten Zeitdauer.

Zudem wird während eines ersten Zeitraums innerhalb dieser ersten Zeitdauer ein von einem Testobjekt reflektiertes oder transmittiertes Licht im Bereich der ersten spektralen Verteilung erfasst. Dieser Schritt detektiert somit das von dem Objekt reflektierte oder transmittierte Licht, welches von dem Konversionsfarbstoff nicht konvertiert während des ersten Zeitraums auf das Objekt trifft. Im zeitlich darauffolgenden Schritt S4 wird nun der von dem Testobjekt reflektierte oder transmittierte Anteil des konvertierten Lichts detektiert. Die Detektion erfolgt während einer zweiten Zeitdauer, die sich an die erste Zeitdauer anschließt. Hierbei kann sich zweite Zeitdauer unmittelbar an die erste Zeitdauer anschließen, es ist jedoch auch möglich, dass zwischen Beginn eines Erfassens des Anteils des konvertierten Lichts und dem während der ersten Zeitdauer aktiven Lichtpuls noch ein geringer Zeitraum liegt.

Durch die unterschiedliche zeitliche Detektion in den Schritten S3 und S4 wird erreicht, dass zum einen lediglich unkonvertiertes bzw. konvertiertes Licht, jedoch keine Mischung daraus erfasst wird. In einem darauffolgenden optionalen Schritt S5 wird, während einer folgenden Periode das Rest- bzw. Umgebungslicht detektiert. Die so erfassten und diktierten Lichtanteile werden im Schritt S6 gemeinsam ausgewertet, um das von dem Testobjekt reflektierte oder transmittierte Spektrum zu erhalten.

Neben den hier vorgestellten einzelnen Verfahrensschritten umfasst Schritt S1 zusätzlich den optionalen Schritt S11. Bei diesem wird ein zweiter Konversionsfarbstoff bereitgestellt, der ausgestaltet ist, Licht in der ersten spektralen Verteilung in Licht mit einer dritten spektralen Verteilung mit infraroten Bereich zu konvertieren. Dabei zeichnet sich der zweite Konversionsfarbstoff im Besonderen durch eine Lumineszenzlebensdauer aus, die länger ist als die Lumineszenzlebensdauer des ersten Konversionsfarbstoffs. Während des Schritts S2 somit durch den Lichtimpuls nicht nur der erste Konversionsfarbstoff, sondern beide Konversionsfarbstoffe angeregt. Im darauffolgenden optionalen Schritt S41 wird nach der Detektion des konvertierten Lichts des ersten Konversionsfarbstoffs nun auch ein Lichtanteil detektiert, der von dem Testobjekt reflektiert bzw. transportiert wird und zu dem konvertierten Licht mit der dritten spektralen Verteilung korrespondiert.

Figur 5 zeigt eine weitere Ausführungsform, bei der nicht nur ein optoelektronisches Bauelement, sondern mehrere optoelektronische Bauelemente nacheinander aktiviert und deren jeweilige Konversions-farbstoffe K1, K2, K3 zumindest angeregt werden. Die Ansteuerung der einzelnen optoelektronischen Bauelemente als auch die Detektion der Signale erfolgt somit zeitlich versetzt. In der Ausführung wird während der ersten Zeitdauer T2 ein erstes optoelektronisches Bauelement angeschaltet und somit der erste Konversionsfarbstoff K1 angeregt. In diesem Ausführungsbeispiel ist die Lumineszenzlebensdauer des Konversionsfarbstoffs K1 so gewählt, dass eine Lumineszenz erst nach Ablauf der zweiten Zeitdauer eintritt. Ein nicht absorbierter Lichtanteil kann somit während der gesamten zweiten Zeitdauer T2 detektiert werden. Dadurch kann der erste Zeitraum für die Detektion des reflektierten bzw. transmittierten Signals gleich der zweiten Zeitdauer gewählt werden.

Zum Zeitpunkt t3 bis zum Zeitpunkt t4 wird nun das von dem ersten Konversionsfarbstoffs K1 abgegebene konvertierte Licht detektiert. Selbiges liegt in einem bekannten Bereich des infraroten Spektrums, welches unterschiedlich zu den Konversionsspektren der beiden anderen Konversionsfarbstoffe K2 und K3 ist. Zum Zeitpunkt t10 ist das Lumineszenzlicht des ersten Konversions-farbstoffs K1 ausreichend abgeklungen, sodass ein weiterer neuer Lichtpuls in einem zweiten optoelektronischen Bauelementen erzeugt wird. Der Lichtpuls des zweiten optoelektronischen Bauelements regt einen zweiten Konversionsfarbstoff K2 an und "pumpt" diese in im angeregten Zustand. Wegen der Lumineszenzlebensdauer des Farbstoffs K2 wird während dieses Zeitraums kein Lumineszenzlicht erzeugt. Somit wird ein nicht absorbierter Anteil des Lichts des zweiten optoelektronischen Bauelements während dieser Zeitdauer T2 erfasst. Die Lumineszenz des zweiten Konversionsfarbstoffs K2 erfolgt auch in dieser Ausführung nach dem Zeitpunkt t11, d. h. nach dem Abschalten des Lichtpulses während der anschließenden Zeitdauer T3. Zwischen den Zeitpunkten t12 und t13 wird der Anteil des vom Konversionsfarbstoffs K2 konvertierten Lichts detektiert. Schließlich wird nach Abklingen des Lichts des Konversionsfarbstoffs K2 ein drittes optoelektronisches Bauelement zum Zeitpunkt t14 angeschaltet und ein Lichtpuls auf den dritten Konversionsfarbstoff K3 gegeben. Die Lumineszenz des dritten Konversionsfarbstoffs wird während der Zeitdauer T3 zwischen den Zeitpunkten t16 bis t17 erfasst.

Durch diese hintereinander geschaltete Aktivierung optoelektronischer Bauelemente mit einer darauffolgenden Detektion eines nicht konvertierten und konvertierten Lichtanteils kann somit ein von einem Testobjekt reflektiertes bzw. transmittiertes Spektrum breitbandig erfasst und ausgewertet werden.

Figur 6 zeigt diesbezüglich die einzelnen Schritte eines derartigen Verfahrens. In Schritt S1 werden die verschiedenen optoelektronischen Bauelemente sowie die dazugehörigen Konversionsfarbstoffe bereitgestellt. Sodann erfolgt in dem darauffolgenden Schritt S2 eine Aktivierung eines ersten optoelektronischen Bauelements sowie ein gleichzeitiges Erfassen des nicht konvertierten aber von dem Testobjekt reflektierten bzw. transmittierten Lichtanteils. Nach dem Lichtpuls wird nun das von dem Konversionsfarbstoff abgestrahlte konvertierte Licht, welches vom Testobjekt reflektiert oder transmittiert wird, erneut in Schritt S4 erfasst. Diese beiden Schritte S2 und S4 werden in Schritt S7 solange wiederholt, bis alle, optoelektronischen Bauelemente wenigstens einmal aktiviert worden sind. Dadurch wird ein breitbandiges Spektrum sowohl im sichtbaren als auch im Infrarotbereich aufgenommen.

Anschließend wird noch eine weitere Messung zur Detektion des Umgebungslichts in Schritt S5 durchgeführt. Die so ermittelte Signalintensität eines Rest- bzw. Umgebungslichts wird mit den Resultaten aus den vorangegangenen Schritten in Schritt S6 verrechnet und ausgewertet.

Es versteht sich, dass die hierin offenbarte Offenbarung nicht auf die bestimmten Bestandteile der beschriebenen Vorrichtungen oder Schritte der beschriebenen Verfahren beschränkt ist, da eine solche Vorrichtung und ein solches Verfahren variieren können. Es versteht sich auch, dass die hierin verwendete Terminologie nur zum Zweck der Beschreibung bestimmter Ausführungsformen dient und nicht einschränkend sein soll. Es ist anzumerken, dass, wie in der Beschreibung und im beigefügten Anspruch verwendet, die bestimmten und unbestimmten Artikel bedeuten sollen, dass es eines oder mehrere der Elemente gibt, außer im Zusammenhang diktiert ausdrücklich etwas anderes. So kann beispielsweise die Bezugnahme auf "eine Einheit" oder "die Einheit" mehrere Vorrichtungen und dergleichen umfassen. Darüber hinaus schließen die Wörter "umfassend", "umfassend", "enthaltend" und ähnliche Formulierungen andere Elemente oder Schritte nicht aus.

### BEZUGSZEICHENLISTE

- 2: Kontrollschaltung
- 3: optischer Sensor, Fotodiode
- 10: Spektrokopieanordnung
- 21, 22: Ausgang
- 23, 24: Ausgang
- 25: Eingang
- t₁, t₂: Zeitpunkt
- t₃, t₄: Zeitpunkt
- t₅, t₆: Zeitpunkt
- t₇, t₈: Zeitpunkt
- t₁₁, t₁₂: Zeitpunkt
- t₁₃, t₁₄: Zeitpunkt
- t₁₅, t₁₆: Zeitpunkt
- t₁₇: Zeitpunkt
- T1: Zeitraum
- T2, T3: Zeitdauer
- T4, T5: Zeitdauer
- K1, K2: Konversionsfarbstoff
- K3: Konversionsfarbstoff
- S1, S2: Verfahrenschritt
- S3, S4: Verfahrenschritt
- S5, S6: Verfahrenschritt

## Patentansprüche

1. Verfahren zur zeitlich differenzierten Detektion eines Spektrums eines Testobjektes, umfassend die Schritte:
- Bereitstellen (S1) eines ersten Konversionsfarbstoffes (K1), der ausgestaltet ist, Licht in einer ersten spektralen Verteilung im sichtbaren Bereich in Licht einer zweiten spektralen Verteilung im infraroten Bereich zu konvertieren;
- Anregen (S2) des ersten Konversionsfarbstoffes (K1) mit einem Lichtpuls im Bereich der ersten spektralen Verteilung während einer ersten Zeitdauer (T₂);
- Erfassen (S3) während eines ersten Zeitraums (T₁) eines von dem Testobjekt reflektierten oder transmittierten Lichtanteils im Bereich der ersten spektralen Verteilung;
- Erfassen (S4) eines von dem Testobjekt reflektierten oder transmittierten Lichtanteils des konvertierten Lichts während einer zweiten Zeitdauer (T₃) nach der ersten Zeitdauer (T₂) ;
wobei der erste Zeitraum (T₁) so gewählt ist, dass der erste Zeitraum (T₁) innerhalb einer Lumineszenzlebensdauer für den ersten Konversionsfarbstoff in der ersten Zeitdauer (T₂) liegt.

2. Das Verfahren nach einem der vorherigen Ansprüche, bei dem der erste Zeitraum so gewählt ist, dass im Wesentlichen kein Lichtanteil des konvertierten Lichts erfasst wird.

3. Das Verfahren nach einem der vorherigen Ansprüche, wobei sich die zweite Zeitdauer (T₂) an die erste Zeitdauer (T₂) unmittelbar anschließt.

4. Das Verfahren nach einem der vorherigen Ansprüche, weiter umfassend ein
- Bereitstellen (S11) eines zweiten Konversionsfarbstoffes (K2), der ausgestaltet ist, Licht in der ersten spektralen Verteilung in Licht mit einer dritten spektralen Verteilung im infraroten Bereich zu konvertierten;
- Anregen des zweiten Konversionsfarbstoffs (K2) mit dem ersten Lichtpuls;
- Erfassen eines von dem Testobjekt reflektierten oder transmittierten Lichtanteils des konvertierten Lichts mit der dritten spektralen Verteilung während einer dritten Zeitdauer nach der zweiten Zeitdauer (T₃).

5. Das Verfahren nach Anspruch 4, bei dem eine Lumineszenzlebensdauer des zweiten Konversionsfarbstoffs (K2) länger ist als eine Summe aus der ersten und der zweiten Zeitdauer (T₂, T₃) ist.

6. Das Verfahren nach Anspruch 4 oder 5, bei dem die dritte spektrale Verteilung zumindest nicht vollständig überlappend zu der zweiten spektralen Verteilung ist.

7. Das Verfahren nach einem der Ansprüche 4 bis 6, bei dem ein Beginn der dritten Zeitdauer von einer Relaxationsdauer des ersten Konversionsfarbstoffs abhängt, und im Besonderen so gewählt ist, dass im Wesentlichen keine Lumineszenz durch den ersten Konversionsfarbstoff mehr stattfindet.

8. Das Verfahren nach einem der Ansprüche 1 bis 3, weiter umfassend ein
- Bereitstellen eines zweiten Konversionsfarbstoffes (K2), der ausgestaltet ist, Licht in der ersten spektralen Verteilung oder in einer vierten spektralen Verteilung in Licht mit einer dritten spektralen Verteilung im infraroten Bereich zu konvertierten;
- Anregen des zweiten Konversionsfarbstoffes (K2) mit einem Lichtpuls im Bereich der ersten spektralen Verteilung oder der vierten spektralen Verteilung während einer fünften Zeitdauer;
- Erfassen während eines zweiten Zeitraums eines von dem Testobjekt reflektierten oder transmittierten Lichtanteils im Bereich der ersten spektralen Verteilung oder der vierten spektralen Verteilung;
- Erfassen eines von dem Testobjekt reflektierten oder transmittierten Lichtanteils des konvertierten Lichts während einer sechsten Zeitdauer nach der fünften Zeitdauer;
wobei der zweite Zeitraum so gewählt ist, dass der zweite Zeitraum im Wesentlichen innerhalb einer Lumineszenzlebensdauer für den zweiten Konversionsfarbstoff (K2) in der fünften Zeitdauer liegt.

9. Das Verfahren nach Anspruch 8, bei dem die fünfte Zeitdauer nach der dritten Zeitdauer liegt.

10. Das Verfahren nach einem der vorherigen Ansprüche, bei dem der erste und/oder zweite Konversionsfarbstoff (K1, K2) so ausgestaltet ist, dass ein Teil des Licht mit der ersten spektralen Verteilung oder der dritten spektralen Verteilung im sichtbaren Bereich durch den Farbstoff nicht konvertiert wird.

11. Das Verfahren nach einem der vorherigen Ansprüche, bei dem der erste Konversionsfarbstoff so ausgestaltet ist, dass Licht mit der ersten spektralen Verteilung im sichtbaren Bereich von 30 % bis 70 %, und im Besonderen zu 45 % bis 55 % konvertiert wird.

12. Das Verfahren nach einem der vorherigen Ansprüche, weiter umfassend den Schritt eines
- Erfassen des Umgebungslichtanteils während einer vierten Zeitdauer, wobei die vierte Zeitdauer (T₄) nach einer aus der zweiten Zeitdauer (T₃), dritten Zeitdauer (T₅) und sechsten Zeitdauer liegt.

13. Das Verfahren nach Anspruch 12, bei dem ein Beginn der vierten Zeitdauer von einer Relaxationsdauer des ersten und/oder zweiten Konversionsfarbstoffs abhängt, und im Besonderen so gewählt ist, dass im Wesentlichen keine Lumineszenz im ersten und/oder zweiten Konversionsfarbstoff mehr stattfindet.

14. Das Verfahren nach einem der vorherigen Ansprüche, weiter umfassend:
- Auswerten des während des ersten Zeitraums und während der zweiten Zeitdauer erfassten Lichtanteils.

15. Spektroskopieanordnung; umfassend:
- wenigstens ein erstes optoelektronisches Bauelement (11,12, 13, 14), welches ausgestaltet ist, in einem Betrieb Licht in einem Bereich einer ersten spektralen Verteilung im sichtbaren Bereich abzugeben;
- ein erster Konversionsfarbstoff (K1), der im Strahlengang des optoelektronischen Bauelements angeordnet und ausgestaltet ist, Licht in einer ersten spektralen Verteilung im sichtbaren Bereich in Licht in einer zweiten spektralen Verteilung im infraroten Bereich zu konvertieren;
- einen optischen Sensor (3), der ausgestaltet ist, Licht in der ersten spektralen Verteilung und in der zweiten spektralen Verteilung zu erfassen;
- eine Kontrollschaltung (2), die mit dem wenigstens einen optoelektronischen Bauelement und dem optischen Sensor gekoppelt und ausgestaltet ist, ein Verfahren nach einem der vorherigen Ansprüchen auszuführen.

16. Spektroskopieanordnung nach Anspruch 15, weiter umfassend
- ein zweiter Konversionsfarbstoff (K2), der im Strahlengang des optoelektronischen Bauelements (11, 12, 13, 14) angeordnet und ausgestaltet ist, Licht in der ersten spektralen Verteilung in Licht in einer dritten spektralen Verteilung im infraroten Bereich zu konvertieren;
- wobei die Kontrollschaltung ausgebildet ist, ein von dem optischen Sensor erzeugtes Signal während einer der zweiten Zeitdauer nachfolgenden dritten Zeitdauer zu erfassen, wobei eine Lumineszenzlebensdauer des zweiten Konversions-farbstoffs länger ist als eine Summe aus der ersten und der zweiten Zeitdauer ist.

17. Spektroskopieanordnung nach einem der Ansprüche 15 bis 16, bei dem ein Beginn der dritten Zeitdauer von einer Relaxationsdauer des ersten Konversionsfarbstoffs abhängt, und im Besonderen so gewählt ist, dass im Wesentlichen keine Lumineszenz durch den ersten Konversionsfarbstoff mehr stattfindet.

18. Spektroskopieanordnung nach einem der Ansprüche 15 bis 17, weiter umfassend:
- ein zweites optoelektronisches Bauelement, welches ausgestaltet ist, in einem Betrieb Licht in einem Bereich einer vierten spektralen Verteilung im sichtbaren Bereich abzugeben;
- ein zweiter Konversionsfarbstoff (K2), der im Strahlengang des zweiten optoelektronischen Bauelements angeordnet und ausgestaltet ist, Licht in der vierten spektralen Verteilung in Licht in einer dritten spektralen Verteilung im infraroten Bereich zu konvertierten;
- wobei die Kontrollschaltung ausgebildet ist, während einer fünften Zeitdauer das zweite optoelektronische Bauelement zur Erzeugung eines zweiten Lichtpulses anzusteuern; und ein von dem optischen Sensor (3) erzeugtes Signal während eines zweiten Zeitraums innerhalb der fünften Zeitdauer und während einer der fünften Zeitdauer nachfolgenden sechsten Zeitdauer liegt,
wobei der zweite Zeitraum so gewählt ist, dass dieser im Wesentlichen innerhalb einer Lumineszenzlebensdauer für den zweiten Konversionsfarbstoff (K2) in der fünften Zeitdauer liegt.

19. Spektroskopieanordnung nach einem der Ansprüche 15 bis 18, bei dem die Kontrollschaltung (2) ausgestaltet ist, ein von dem optischen Sensor (3) erzeugtes Signal während einer vierten Zeitdauer zu erfassen, wobei die vierte Zeitdauer nach einer aus der zweiten Zeitdauer, dritten Zeitdauer und sechsten Zeitdauer liegt.

20. Spektroskopieanordnung nach Anspruch 19, bei dem ein Beginn der vierten Zeitdauer von einer Relaxationsdauer des ersten und/oder zweiten Konversionsfarbstoffs (K1, K2) abhängt, und im Besonderen so gewählt ist, dass im Wesentlichen keine Lumineszenz im ersten und/oder zweiten Konversionsfarbstoff mehr stattfindet.

## Claims

1. Method for the time-differentiated detection of a spectrum of a test object, comprising the steps:
- providing (S1) a first conversion dye (K1), which is configured to convert light in a first spectral distribution in the visible range into light of a second spectral distribution in the infrared range;
- exciting (S2) the first conversion dye (K1) with a light pulse in the range of the first spectral distribution during a first time period (T₂);
- registering (S3) during a first time interval (T₂) a light fraction, reflected or transmitted by the test object, in the range of the first spectral distribution;
- registering (S4) a light fraction of the converted light, reflected or transmitted by the test object, during a second time period (T₃) after the first time period (T₂);
wherein the first time interval (T₁) is selected so that the first time interval (T₂) lies substantially inside a luminescence lifetime for the first conversion dye in the first time period (T₂).

2. Method according to any of the preceding claims, wherein the first time interval is selected so that substantially no light fraction of the converted light is registered.

3. Method according to any of the preceding claims, wherein the second time period (T₃) directly follows the first time period (T₂) .

4. Method according to any of the preceding claims, furthermore comprising
- providing (S11) a second conversion dye (K2), which is configured to convert light in the first spectral distribution into light with a third spectral distribution in the infrared range;
- exciting the second conversion dye (K2) with the first light pulse;
- registering a light fraction, reflected or transmitted by the test object, of the converted light with the third spectral distribution during a third time period after the second time period (T₃).

5. Method according to Claim 4, wherein a luminescence lifetime of the second conversion dye (K2) is longer than a sum of the first and second time periods (T₂, T₃).

6. Method according to Claim 4 or 5, wherein the third spectral distribution at least does not fully overlap with the second spectral distribution.

7. Method according to any of Claims 4 to 6, wherein a start of the third time period depends on a relaxation time of the first conversion dye, and in particular is selected so that luminescence by the first conversion dye is substantially no longer taking place.

8. Method according to any of Claims 1 to 3, furthermore comprising
- providing a second conversion dye (K2), which is configured to convert light in the first spectral distribution or in a fourth spectral distribution into light with a third spectral distribution in the infrared range;
- exciting the second conversion dye (K2) with a light pulse in the range of the first spectral distribution or of the fourth spectral distribution during a fifth time period;
- registering during a second time interval a light fraction, reflected or transmitted by the test object, in the range of the first spectral distribution or of the fourth spectral distribution;
- registering a light fraction, reflected or transmitted by the test object, of the converted light during a sixth time period after the fifth time period;
wherein the second time interval is selected so that the second time interval lies substantially inside a luminescence lifetime for the second conversion dye (K2) in the fifth time period.

9. Method according to Claim 8, wherein the fifth time period lies after the third time period.

10. Method according to any of the preceding claims, wherein the first and/or second conversion dye (K1, K2) is configured so that a part of the light with the first spectral distribution or the third spectral distribution in the visible range is not converted by the dye.

11. Method according to any of the preceding claims, wherein the first conversion dye is configured so that light with the first spectral distribution in the visible range is converted from 30% to 70%, and in particular to 45% to 55%.

12. Method according to any of the preceding claims, furthermore comprising the step of
- registering the ambient light fraction during a fourth time period, the fourth time period (T₄) lying after one of the second time period (T₃), third time period (T₅) and sixth time period.

13. Method according to Claim 12, wherein a start of the fourth time period depends on a relaxation time of the first and/or second conversion dye, and in particular is selected so that luminescence in the first and/or second conversion dye is substantially no longer taking place.

14. Method according to any of the preceding claims, furthermore comprising:
- evaluating the light fraction registered during the first time interval and during the second time period.

15. Spectroscopy arrangement, comprising:
- at least a first optoelectronic component (11, 12, 13, 14), which is configured during operation to emit light in a range of a first spectral distribution in the visible range;
- a first conversion dye (K1), which is arranged in the beam path of the optoelectronic component and is configured to convert light in a first spectral distribution in the visible range into light in a second spectral distribution in the infrared range;
- an optical sensor (3), which is configured to register light in the first spectral distribution and in the second spectral distribution;
- a control circuit (2), which is coupled to the at least one optoelectronic component and the optical sensor and is configured to carry out a method according to any of the preceding claims.

16. Spectroscopy arrangement according to Claim 15, furthermore comprising
- a second conversion dye (K2), which is arranged in the beam path of the optoelectronic component (11, 12, 13, 14) and is configured to convert light in the first spectral distribution into light in a third spectral distribution in the infrared range;
- wherein the control circuit is configured to register a signal generated by the optical sensor during a third time period following the second time period, a luminescence lifetime of the second conversion dye being longer than a sum of the first and second time periods.

17. Spectroscopy arrangement according to either of Claims 15 to 16,
wherein a start of the third time period depends on a relaxation time of the first conversion dye, and in particular is selected so that luminescence by the first conversion dye is substantially no longer taking place.

18. Spectroscopy arrangement according to any of Claims 15 to 17, furthermore comprising:
- a second optoelectronic component, which is configured during operation to emit light in a range of a fourth spectral distribution in the visible range;
- a second conversion dye (K2), which is arranged in the beam path of the second optoelectronic component and is configured to convert light in the fourth spectral distribution into light in a third spectral distribution in the infrared range;
- wherein the control circuit is configured, during a fifth time period, to drive the second optoelectronic component in order to generate a second light pulse; and a signal generated by the optical sensor (3) during a second time interval inside the fifth time period and during a sixth time period following the fifth time period,
wherein the second time interval is selected so that it substantially lies inside a luminescence lifetime for the second conversion dye (K2) in the fifth time period.

19. Spectroscopy arrangement according to any of Claims 15 to 18, wherein the control circuit (2) is configured to register a signal generated by the optical sensor (3) during a fourth time period, the fourth time period lying after one of the second time period, third time period and sixth time period.

20. Spectroscopy arrangement according to Claim 19, wherein a start of the fourth time period depends on a relaxation time of the first and/or second conversion dye (K1, K2), and in particular is selected so that luminescence in the first and/or second conversion dye is substantially no longer taking place.

## Revendications

1. Procédé de détection différenciée dans le temps d'un spectre d'un objet de test, ledit procédé comprenant les étapes suivantes :
- fournir (S1) un premier colorant de conversion (Kl), qui est conçu pour convertir une lumière dans une première distribution spectrale dans le domaine visible en une lumière dans une deuxième distribution spectrale dans le domaine infrarouge ;
- exciter (S2) le premier colorant de conversion (Kl) avec une impulsion lumineuse dans la zone de la première distribution spectrale pendant une première durée (T₂) ;
- détecter (S3) pendant une première durée (T₂) une proportion de lumière, réfléchie ou transmise par l'objet de test, dans la zone de la première distribution spectrale ;
- détecter (S4) une proportion de lumière, réfléchie ou transmise par l'objet de test, de la lumière convertie pendant une deuxième durée (T₃) après la première durée (T₂) ;
la première durée (T₁) étant choisie de telle sorte que la première durée (T₁) soit située dans la première durée (T₂) dans une durée de vie de luminescence du premier colorant de conversion.

2. Procédé selon l'une des revendications précédentes, dans lequel la première durée est choisie de telle sorte que sensiblement aucune proportion de lumière de la lumière convertie ne soit détectée.

3. Procédé selon l'une des revendications précédentes, la deuxième durée (T₃) faisant immédiatement suite à la première durée (T₂) .

4. Procédé selon l'une des revendications précédentes, comprenant en outre les étapes suivantes :
- fournir (S11) un deuxième colorant de conversion (K2), qui est conçu pour convertir la lumière dans la première distribution spectrale en une lumière ayant une troisième distribution spectrale dans le domaine infrarouge ;
- exciter le deuxième colorant de conversion (K2) avec la première impulsion lumineuse ;
- détecter une proportion de lumière, réfléchie ou transmise par l'objet de test, de la lumière convertie ayant la troisième distribution spectrale pendant une troisième durée après la deuxième durée (T₃).

5. Procédé selon la revendication 4, dans lequel une durée de vie de luminescence du deuxième colorant de conversion (K2) est plus longue que la somme des première et deuxième durées .

6. Procédé selon la revendication 4 ou 5, dans lequel la troisième distribution spectrale chevauche au moins en partie la deuxième distribution spectrale.

7. Procédé selon l'une des revendications 4 à 6, dans lequel le début de la troisième durée dépend d'une durée de relaxation du premier colorant de conversion, et est en particulier choisi de telle sorte que sensiblement plus aucune luminescence ne soit produite par le premier colorant de conversion.

8. Procédé selon l'une des revendications 1 à 3, comprenant en outre les étapes suivantes :
- fournir un deuxième colorant de conversion (K2), qui est conçu pour convertir la lumière dans la première distribution spectrale ou dans une quatrième distribution spectrale en une lumière ayant une troisième distribution spectrale dans le domaine infrarouge ;
- exciter le deuxième colorant de conversion (K2) avec une impulsion lumineuse dans la zone de la première distribution spectrale ou de la quatrième distribution spectrale pendant une cinquième durée ;
- détecter pendant une deuxième durée une proportion de lumière, réfléchie ou transmise par l'objet de test, dans la zone de la première distribution spectrale ou de la quatrième distribution spectrale ;
- détecter une proportion de lumière, réfléchie ou transmise par l'objet de test, de la lumière convertie pendant une sixième durée après la cinquième durée ;
la deuxième durée étant choisie de façon à être située dans la cinquième durée sensiblement dans une durée de vie de luminescence du deuxième colorant de conversion (K2).

9. Procédé selon la revendication 8, dans lequel la cinquième durée est située après la troisième durée.

10. Procédé selon l'une des revendications précédentes, dans lequel le premier et/ou le deuxième colorant de conversion (K1, K2) sont conçus de telle sorte qu'une partie de la lumière ayant la première distribution spectrale ou la troisième distribution spectrale dans le domaine visible ne soit pas convertie par le colorant.

11. Procédé selon l'une des revendications précédentes, dans lequel le premier colorant de conversion est conçu de telle sorte que la lumière ayant la première distribution spectrale dans le domaine visible soit convertie de 30 % à 70 %, et en particulier de 45 % à 55 %.

12. Procédé selon l'une des revendications précédentes, comprenant en outre l'étape suivante :
- détecter la proportion de lumière ambiante pendant une quatrième durée, la quatrième durée (T₄) étant située après la deuxième durée (T₃), la troisième durée (T₅) et la sixième durée.

13. Procédé selon la revendication 12, dans lequel le début de la quatrième durée dépend d'une durée de relaxation du premier et/ou du deuxième colorant de conversion, et est notamment choisie de manière à ce que sensiblement plus aucune luminescence ne se produise dans le premier et/ou le deuxième colorant de conversion.

14. Procédé selon l'une des revendications précédentes, comprenant en outre l'étape suivante :
- évaluer la proportion de lumière détectée pendant la première durée et pendant la deuxième durée.

15. Ensemble de spectroscopie, comprenant :
- au moins un premier composant optoélectronique (11, 12, 13, 14), qui est conçu pour émettre une lumière dans une zone d'une première distribution spectrale dans le domaine visible pendant le fonctionnement ;
- un premier colorant de conversion (K1), qui est disposé dans le trajet de faisceau du composant optoélectronique et qui est conçu pour convertir la lumière ayant une première distribution spectrale dans le domaine visible en une lumière ayant une deuxième distribution spectrale dans le domaine infrarouge ;
- un capteur optique (3) qui est conçu pour détecter la lumière dans la première distribution spectrale et dans la deuxième distribution spectrale ;
- un circuit de commande (2), qui est couplé à l'au moins un composant optoélectronique et au capteur optique et qui est conçu pour mettre en œuvre un procédé selon l'une des revendications précédentes.

16. Ensemble de spectroscopie selon la revendication 15, comprenant en outre
- un deuxième colorant de conversion (K2), qui est disposé dans le trajet de faisceau du composant optoélectronique (11, 12, 13, 14) et qui est conçu pour convertir la lumière dans la première distribution spectrale en une lumière dans une troisième distribution spectrale dans le domaine infrarouge ;
- le circuit de commande étant conçu pour détecter un signal, généré par le capteur optique, pendant une troisième durée suivant la deuxième durée, la durée de vie de luminescence du deuxième colorant de conversion étant plus longue que la somme des première et deuxième durées.

17. Ensemble de spectroscopie selon l'une des revendications 15 à 16, dans lequel le début de la troisième durée dépend d'une durée de relaxation du premier colorant de conversion, et est en particulier choisi de manière à ce que sensiblement plus aucune luminescence ne soit produite par le premier colorant de conversion.

18. Ensemble de spectroscopie selon l'une des revendications 15 à 17, comprenant en outre :
- un deuxième composant optoélectronique, conçu pour émettre de la lumière dans une zone d'une quatrième distribution spectrale dans le domaine visible pendant le fonctionnement ;
- un deuxième colorant de conversion (K2), qui est disposé dans le trajet de faisceau du deuxième composant optoélectronique et qui est conçu pour convertir la lumière dans la quatrième distribution spectrale en une lumière dans une troisième distribution spectrale dans le domaine infrarouge ;
- le circuit de commande étant conçu pour commander le deuxième composant optoélectronique pendant une cinquième durée afin de générer une deuxième impulsion lumineuse ; et un signal généré par le capteur optique (3) étant situé pendant une deuxième durée dans la cinquième durée et pendant une sixième durée après la cinquième durée,
la deuxième durée étant choisie de façon à être située sensiblement dans une durée de vie de luminescence du deuxième colorant de conversion (K2) dans la cinquième durée.

19. Ensemble de spectroscopie selon l'une des revendications 15 à 18, dans lequel le circuit de commande (2) est conçu pour détecter un signal, généré par le capteur optique (3), pendant une quatrième durée, la quatrième durée étant située après la deuxième durée, la troisième durée et la sixième durée.

20. Ensemble de spectroscopie selon la revendication 19, dans lequel un début de la quatrième durée dépend d'une durée de relaxation du premier et/ou du deuxième colorant de conversion (K1, K2), et en particulier est choisi de telle sorte que sensiblement plus aucune luminescence ne se produise dans le premier et/ou le deuxième colorant de conversion.
